Europäisches Patentamt

European Patent Office

Office européen des brevets

(19)

(11) Numéro de publication : **0 104 293**
**B1**

(12)

# FASCICULE DE BREVET EUROPÉEN

(45) Date de publication du fascicule du brevet : .
30.12.86

(51) Int. Cl.⁴ : **G 06 F 11/26**

(21) Numéro de dépôt : 82430028.9

(22) Date de dépôt : 28.09.82

(54) Dispositif pour le chargement et la lecture de différentes chaînes de bascules dans un système de traitement de données.

(43) Date de publication de la demande :
04.04.84 Bulletin 84/14

(45) Mention de la délivrance du brevet :
30.12.86 Bulletin 86/52

(84) Etats contractants désignés :
DE FR GB

(56) Documents cités :
DE-A- 1 927 549
FR-A- 2 386 865
US-A- 3 964 088
US-A- 4 183 461
US-A- 4 326 266
1979 IEEE TEST CONFERENCE, DIGEST OF PAPERS,
23-25 octobre 1979, pages 29-36, Session 2: "LSI &
Boards, Cherry Hill, N.J., USA. L. A. STOLTE et al.:
"Design for testability of the ibm system/38"
ELECTRONICS, vol. 52, no. 6, 15 mars 1979, pages
.108-110, New York, USA. N. C. BERGLUND: Levelsensitive scan design tests chips, boards, system"

(73) Titulaire : **International Business Machines Corporation**
**Old Orchard Road**
**Armonk, N.Y. 10504 (US)**
**DE GB**
**Compagnie IBM FRANCE**
**5 Place Vendôme**
**F-75000 Paris 1er (FR)**
**FR**

(72) Inventeur : **Dupuy d'Angeac, Didier**
**8, rue du Farnet**
**F-06510 Carros (FR)**
Inventeur : **Lechaczynski, Michel André**
**17, avenue Georges Clémenceau**
**F-06000 Nice (FR)**
Inventeur : **Pauporte, André**
**Lotissement du Colombier**
**F-06480 La Colle sur Loup (FR)**
Inventeur : **Thery, Pierre**
**Villa Sunny Land Allée Venet**
**F-06160 Juan les Pins (FR)**

(74) Mandataire : **Lattard, Nicole**
**Compagnie IBM France Département de Propriété
Intellectuelle**
**F-06610 La Gaude (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

**Description**

Domaine technique

La présente invention concerne un dispositif pour le chargement et la lecture de données dans différentes chaînes de bascules d'un système de traitement de données en vue du test et de la localisation des pannes ou de l'initialisation du système. Elle concerne plus particulièrement un tel dispositif utilisable pour envoyer des données de test ou d'initialisation aux différentes chaînes de bascules d'un système réalisé en suivant les règles de la technique de conception avec analyse sensible au niveau (Level Sensitive Scan Design LSSD).

Ainsi qu'il est décrit dans l'article paru dans la revue « Electronics » du 15 mars 1979 aux pages 108 à 110, l'intégration de plus en plus poussée des circuits logiques composant les machines a conduit à la nécessité de concevoir les circuits de façon que le test en soit possible aux différents stades de la réalisation : conception et fabrication et ultérieurement lorsque la machine est installée et qu'il faut localiser les pannes. La conception des circuits avec analyse sensible au niveau (LSSD : Level Sensitive Scan Design) décrite dans cet article permet de faciliter le test de même que l'initialisation des circuits.

Dans les machines conçues suivant la technique LSSD, les circuits logiques sont intégrés dans des blocs assemblés sur des cartes elles-mêmes enfichées sur des panneaux. Ainsi qu'il est décrit dans l'article, le test des blocs nécessite l'envoi et la réception des données d'analyse d'entrée et de sortie SDI et SDO ainsi que l'envoi de signaux d'horloge à partir d'un circuit de commande centralisé.

Des éléments d'emmagasinage SRL constitués de deux bascules L1 et L2 disposées comme décrit dans l'article, sont reliés en mode de test, qui sera appelé mode LSSD, pour former une chaîne de bascules constituant un registre à décalage.

Suivant le degré de finesse que l'on désire atteindre, c'est-à-dire quel type de composant défectueux on désire pouvoir isoler, les chaînes sont formées des bascules d'un bloc, ou des chaînes de composants (cartes, panneaux) sont formées.

Le composant que l'on désire pouvoir isoler sera appelé unité remplaçable RU.

Dans les machines comprenant un grand nombre de circuits, le nombre de chaînes à créer pour le test est important et en conséquence le circuit de commande centralisé doit pouvoir envoyer les données de test à chaque chaîne. Ce qui nécessite pour chaque chaîne quatre bornes d'entrée/sortie et quatre lignes : SDI, SDO, horloge A et B. Le circuit de commande centralisé est réalisé sous forme d'un circuit intégré VLSI et actuellement le nombre des entrées/sorties doit être réduit au minimum. En effet, ajouter quelques circuits n'ajoute que très peu au prix des machines mais avoir beaucoup d'entrées/sorties aux blocs de circuits intégrés et beaucoup de câbles pour transporter les signaux est très coûteux.

L'article paru dans IEEE en 1979, Test Conference, Digest of Papers 23 au 25 Octobre 1979, aux pages 29 à 36 et le brevet US 4 268 902 décrivent un interface de maintenance, comportant un circuit logique de commande utilisable pour contrôler le chargement et la lecture de chaînes de registres à décalage. Un inconvénient d'un tel circuit est que l'adressage de chaînes ne permet pas de réduire au minimum le nombre de bornes d'entrée/sortie du circuit logique de commande.

Le brevet DE-A 1 927 549 décrit une structure de bus en anneau pour transporter les données et les adresses entre une unité centrale et des unités d'entrée/sortie. Dans cette structure les unités d'entrée/sortie sont connectées au bus d'adresse en parallèle, de façon classique de telle sorte que dans chaque unité d'entrée/sortie un circuit permet de décoder la configuration d'adresse sur le bus d'adresse.

Le brevet US-A 3 964 088 décrit un système de traitement de l'information incorporant diverses unités dans chacune desquelles est créé au moins un registre à décalage. L'adressage d'un registre se fait à l'aide d'au moins une bascule qui est contrôlée par un circuit général comportant un décodeur d'adresse.

Les différentes bascules d'adressage dans les différentes unités sont contrôlées par le circuit général de l'unité, ce qui nécessite un grand nombre de bornes d'entrée/sortie.

En conséquence, un objet de la présente invention est de réaliser un dispositif permettant de charger et de lire des chaînes de bascules dans un système tel qu'une unité de traitement centrale pour les opérations de tests, de diagnostics ou d'initialisation, à partir d'un circuit de commande centralisé qui comporte un nombre minimum de bornes d'entrée/sortie.

Résumé de l'Invention

La présente invention concerne un dispositif de chargement et de lecture de chaînes de bascules à décalage utilisable pour le test, le dépannage et l'initialisation d'un système de traitement de données dont les composants sont disposés sur n unités remplaçables qui comportent chacun p chaînes de bascules. Il comprend un circuit de commande connecté à une boucle de contrôle et à une boucle de données.

Le circuit de commande génère une configuration de bits d'adresse et traite les données à envoyer dans la chaîne sélectionnée et les données reçues de la chaîne sélectionnée.

La boucle de contrôle est connectée au circuit de commande et reçoit de ce dispositif de commande une configuration de bits d'adresse qui sont envoyés en série sur la boucle.

Dans chaque unité remplaçable est disposé un circuit d'adressage sensible à la configuration des bits d'adresse sur la boucle de contrôle, ledit circuit ayant p sorties et fournissant sur une des p sorties, qui est déterminée par la configuration des bits d'adresse, un signal de sélection de chaîne. Ledit circuit d'adressage comporte au moins une bascule d'adressage, et les différentes bascules d'adressage dans les différentes unités remplaçables, sont connectées de façon à constituer un registre à décalage.

Le circuit de commande comprend des premiers moyens · de génération d'impulsion d'horloge qui envoient sur une première ligne de sortie dudit circuit de commande des premières impulsions d'horloge dont le nombre est fonction de l'unité dans laquelle se trouve la chaîne à sélectionner, ces impulsions étant appliquées en parallèle aux bascules d'adressage pour provoquer le décalage de la configuration des bits d'adresse dans le registre formé par les bascules d'adressage.

Toutes les unités remplaçables sont connectées à la boucle de données et par cette boucle, reçoivent du circuit de commande les données à charger dans la chaîne sélectionnée et envoient les données lues de ladite chaîne.

Une première série de p portes d'entrée est placée dans chaque unité remplaçable, chacune desdites portes étant connectée à une des p sorties du circuit d'adressage pour être ouverte par le signal de sélection de chaîne afin d'autoriser le chargement des données provenant de la boucle de données dans la chaîne sélectionnée.

Dans un mode de réalisation préférée, les circuits d'adressage comportent chacun m bascules d'adressage avec $p = 2^m$, les m bascules de tous les circuits étant connectées pour former un registre à décalage, et un sélecteur de chaîne ayant p sorties sensible à l'état des bascules d'adressage pour fournir sur une des p sorties le signal de sélection d'adresse.

Le circuit de commande comprend des seconds moyens de génération d'impulsions d'horloge pour générer sur une seconde ligne de sortie du circuit de commande des secondes impulsions d'horloge lorsque la chaîne à sélectionner a été adressée. Les secondes impulsions sont appliquées à chacune des p portes d'entrée de toutes les unités remplaçables, afin que la porte ouverte par le circuit d'adressage provoque leur application à la chaîne sélectionnée pour y charger les données qui circulent sur la boucle de données.

Chaque unité remplaçable comporte une seconde série de p portes de sortie chacune desdites portes étant ouverte par une des sorties du circuit d'adressage afin de faire passer le contenu de la chaîne sélectionnée sur la boucle de données.

Brève description des figures

La figure 1 représente un arrangement d'un système de l'art antérieur.

La figure 2 représente schématiquement le dispositif de la présente invention.

La figure 3 représente une unité remplaçable permettant de mettre en œuvre le principe de la présente invention dans le cas où il y a une chaîne par unité.

La figure 4 représente une unité remplaçable dans le cas où il y a plusieurs chaînes par unité.

La figure·5 représente la partie du circuit de commande nécessaire au fonctionnement du dispositif de la présente invention.

Description détaillée de l'invention

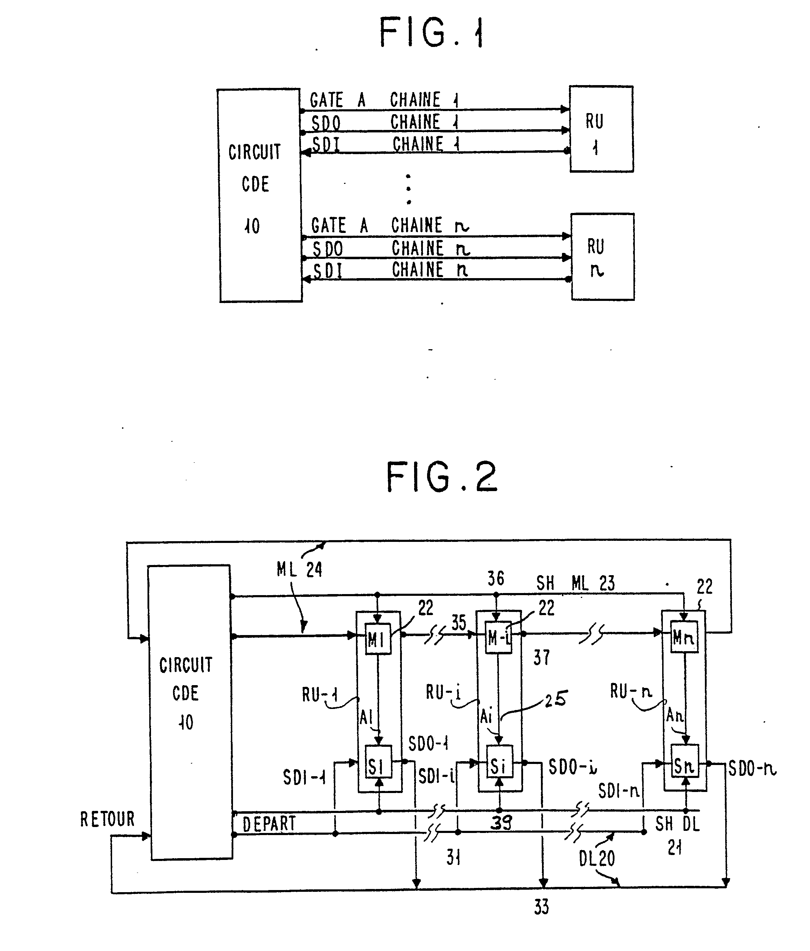

Dans le brevet US A 4 268 902 est décrit un interface de maintenance qui permet de tester un certain nombre d'éléments d'une unité de traitement central. Pour cela quatre chaînes de registres à décalage peuvent être constituées et le circuit logique de commande comporte quatre séries de lignes SDI, SDO. Du fait du nombre restreint des chaînes, le nombre des entrées/sorties n'est pas encore très élevé mais dans les machines de taille importante comportant un grand nombre de blocs disposés sur des cartes le nombre des entrées/sorties du circuit de commande peut devenir très élevé, comme représenté schématiquement sur la figure 1.

Le circuit de commande 10, qui comprend des moyens pour contrôler des horloges et des moyens pour envoyer et recevoir les données en mode LSSD, de façon classique, comporte pour chaque unité remplaçable (dans l'exemple choisi, une carte), une ligne d'entrée de données en mode LSSD SDI, une ligne de sortie de données en mode LSSD SDO et une ligne de contrôle d'envoi de l'horloge A : GATE A. Il est supposé que dans cette machine, le signal de l'horloge B est appliqué en permanence.

La figure .2 représente schématiquement le principe de la présente invention.

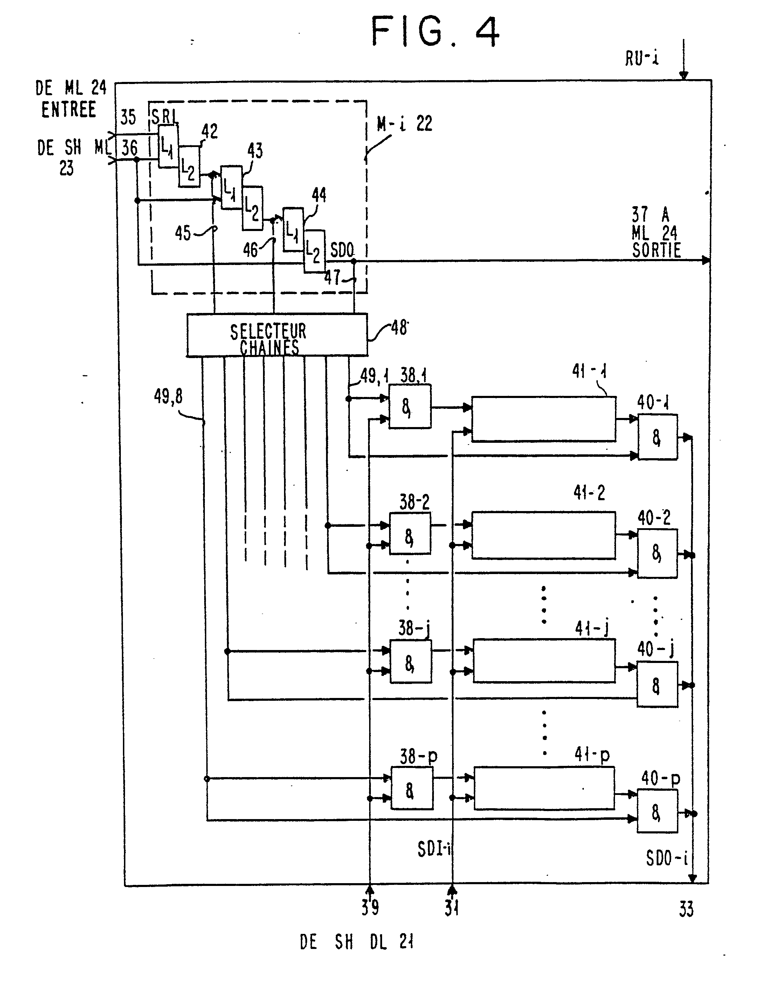

Les données sont envoyées et reçues comme dans les machines antérieures par le circuit de commande 10 sous contrôle d'un microprocesseur par exemple. Dans les unités à tester ou à initialiser RUI à RUn, en mode LSSD, des chaînes SI à Sn de bascules SRL sont constituées dans lesquelles les données à charger dans les chaînes LSSD sont introduites sous contrôle de l'horloge A (SH DL 21). Sur la figure 2 on a représenté schématiquement une seule chaîne dans chaque unité RU. Cependant comme cela sera décrit en référence à la figure 4, chaque unité peut comporter plusieurs chaînes.

Les données sont envoyées sur une boucle de données DL 20, de laquelle les unités RU reçoivent les données d'entrée par les lignes SDI et sur laquelle elles placent les données de sortie par les lignes SDO, sous contrôle des signaux d'horloge A sur la ligne de contrôle de décalage des données SH DL 21.

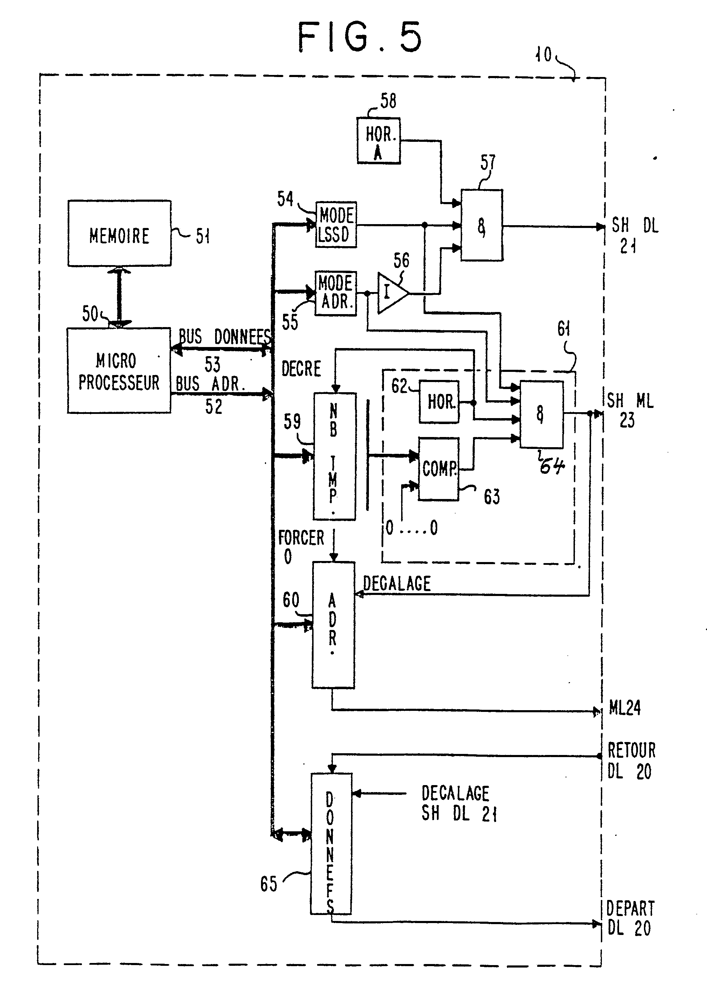

Dans chaque unité RU-i est placé un circuit d'adressage Mi 22 qui comporte au moins une bascule. Chaque bascule du circuit d'adressage reçoit des impulsions d'horloge de décalage du circuit 10 par la ligne SH ML 23. Les bascules de tous les circuits d'adressage sont reliées entre elles pour former un registre à décalage, par une boucle de contrôle ML 24. L'état des bascules des circuits d'adressage Mi 22 dépend de l'information envoyée sur la boucle ML 24 par le circuit 10. Suivant l'état des bascules, le chargement des données dans une chaîne sélectionnée est autorisé. Ceci est représenté schématiquement sur la figure par la ligne Ai 25 dans chacune des unités. Un moyen permettant d'envoyer l'information d'adressage de chaque unité sur la boucle de contrôle ML 24 sera décrit ultérieurement en référence à la figure 5.

Grâce à cet arrangement, pour tester n unités il ne faut que 6 entrées/sorties pour le circuit 1 au lieu de 3 × n dans les systèmes de l'art antérieur tel que représenté dans la figure 1.

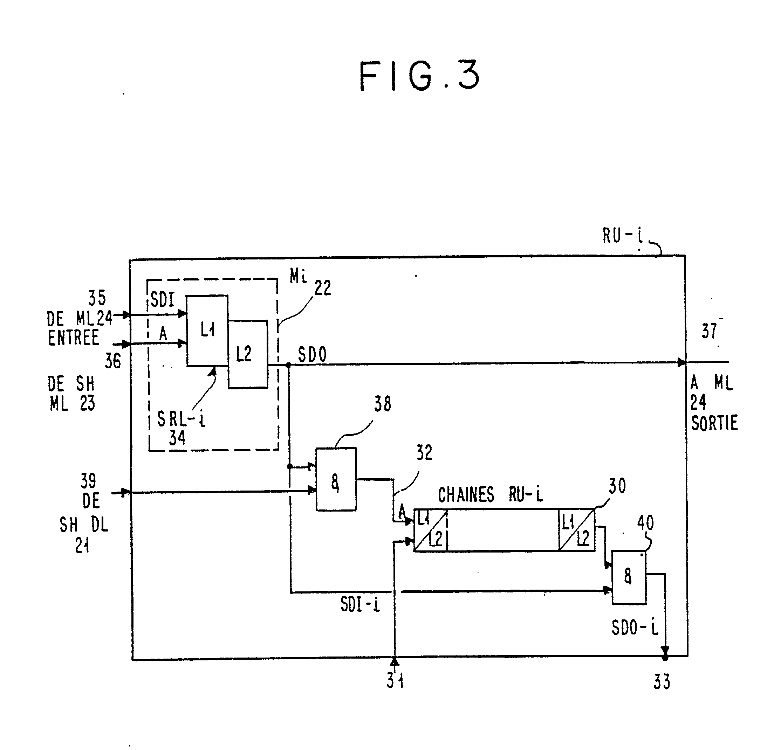

Une unité RU-i ne comportant qu'une chaîne est représentée sur la figure 3.

Sur la figure 2, les numéros de référence 31, 33, 35, 36, 37 et 39 ont été indiqués pour montrer comment est connectée l'unité RU-i dans l'ensemble de la figure 2.

La chaîne des bascules formée dans cette unité pour le test de la logique de l'unité est représentée schématiquement en 30. Cette chaîne constitue un registre à décalage dont chaque étage comporte deux bascules L1, L2 disposées comme représenté sur le schéma de l'article cité en référence. Les données de test en mode LSSD sont appliquées en série à l'entrée SDI-i au point 31, et sous contrôle d'un signal d'horloge sur l'entrée A 32 de chaque bascule, elles sont décalées dans le registre. Les données de sortie à analyser pour réaliser le test ou localiser une panne sont recueillies sur la borne SDO-i au point 33.

La bascule d'adressage Mi de la figure 2 est constituée d'un étage SRL-i 34 comprenant deux bascules L1, L2.

Sur l'entrée SDI de la bascule L1 est appliquée l'information d'adresse qui circule sur la boucle de contrôle ML 24, prise au point 35 (figure 2). L'entrée A de la bascule L1, au point 36, reçoit un signal d'horloge pour mettre à 1 la bascule 34 lorsque l'unité RU-i est adressée ou pour propager cette information aux étages SRL suivants en vue de l'adressage d'une unité sélectionnée par le circuit de commande 10. La sortie SDO de la bascule L2 au point 37 est connectée à l'entrée SDI de la bascule L1 de l'unité suivante pour former la boucle de contrôle ML 24.

Un circuit ET 38 a une de ses entrées connectée à la sortie SDO 37 de la bascule d'adressage 34 et une autre entrée reçoit de la ligne SH DL 21 au point 39 le signal d'horloge A généré dans le circuit de commande 10 lorsque le système est en mode LSSD.

En conséquence si le circuit de commande 10 a provoqué l'adressage de l'unité RU-i en mettant à 1 la bascule SRL-i 34, le signal d'horloge A qui est envoyé par le circuit de commande 10 sur la ligne SH DL 21 est appliqué à la chaîne RU-i 30, par le circuit ET 38 alors ouvert. Les données sur la boucle de données DL 20 prises au point 31 sont donc chargées dans la chaîne 30 par l'entrée SDI-i.

Une porte ET 40 reçoit sur une de ses entrées la sortie de la bascule L2 du dernier étage de la chaîne 30 et sur son autre entrée la sortie SDO 37 de la bascule d'adressage 34. En conséquence lorsque l'unité RU-i a été adressée, les données à analyser sont recueillies à la sortie SDO-i de la porte ET 40 au point 33 et renvoyées au circuit de commande 10 par la boucle de données DL 20.

On va maintenant décrire en référence à la figure 4, l'application du principe décrit en référence aux figures 2 et 3 au test de plusieurs chaînes distinctes à l'intérieur de chaque unité RU-i.

On suppose que dans chaque unité RU-i on désire pouvoir accéder à plusieurs chaînes de bascules 41-1 à 41 p. Sur la figure 4, seules 4 chaînes ont été représentées. Dans un cas particulier, on supposera p égal à 8.

L'unité RU-i est connectée aux boucles de contrôle ML 24 et de données DL 20 de la même façon que dans l'hypothèse précédente décrite en référence à la figure 3. En conséquence les mêmes numéros de références sont utilisés pour référencer les bornes d'entrée/sortie de l'unité RU-i.

Les données sont chargées et extraites des chaînes de la même façon que précédemment décrit. Pour chaque chaîne, deux circuits ET 38-j et 40-j disposés comme les circuits ET 38 et 40 de la figure 3, sont prévus.

Le circuit d'adressage qui provoque l'ouverture des portes est différent.

Le circuit d'adressage Mi comporte plusieurs bascules SRL. Sur la figure 4 trois bascules SRL sont représentées 42, 43, 44 qui fournissent sur leurs sorties 45, 46, 47 trois bits d'adresse, ce qui permet d'adresser 8 chaînes. Le nombre m de bascules dépend du nombre p de chaînes à adresser et est tel que $p = 2^m$.

La première bascule a son entrée SDI connectée à la boucle ML 24 au point 35. Chacune des entrées d'horloge A des trois bascules 42, 43 et 44 reçoit une impulsion de décalage prise au point 36 de la ligne SH ML 23 et fournie par le circuit de commande 10.

La sortie SDO 37 de la bascule 44 est reliée à l'entrée SDI de la première bascule 42 de l'unité suivante par la boucle ML 24.

Les trois bits d'adresse sont appliqués à un circuit sélecteur de chaînes 48 constitué d'un ensemble de portes et d'inverseurs qui fournit sur une de ses sorties 49-1 à 49-8, un signal de sélection de chaîne, en fonction de la configuration des bits d'adresse sur les sorties 45, 46, 47. Par exemple, lorsque la configuration des bits d'adresse est 000, seul le signal sur la sortie 49-1 est à 1 pour ouvrir la porte 38-1 et lorsque la configuration des bits d'adresse est 111, seul le signal sur la ligne 49-8 est à 1 pour ouvrir la porte 38-p (dans le cas où p = 8).

Une fois une chaîne sélectionnée, les données y sont introduites comme dans le cas de la disposition de la figure 3.

Les portes ET de sortie 40-1 à 40-p étant ouvertes par le signal de sélection d'adresse on ne retrouve sur la ligne SDO-i au point 33, que les données de sortie provenant de la chaîne sélectionnée. Ces données sont renvoyées au circuit de commande par la boucle de données DL 20 comme décrit en référence à la fig. 2.

On va maintenant décrire en référence à la figure 5, la partie du circuit de commande 10 utilisée pour envoyer l'information d'adresse sur la boucle de contrôle ML 24, dans l'hypothèse où plusieurs chaînes doivent être adressées dans chaque unité.

Dans un mode de réalisation préféré le circuit de commande est constitué d'un microprocesseur 50 avec sa mémoire 51 dans laquelle sont stockés le programme de commande ainsi que des données. Le microprocesseur communique avec l'extérieur par des registres externes qui sont adressés sous contrôle du programme par le bus d'adresse 52, les données sont transférées dans le registre adressé par le bus de données 53. Sur la figure 5 on a représenté schématiquement 5 registres externes 54, 55, 59, 60 et 65. Le premier 54 est en partie constitué d'une seule bascule qui est mise à 1 lorsque le système est placé en mode LSSD. Le second registre 55 comporte une autre bascule qui est mise à 1 pendant la phase d'adressage. La sortie de la bascule du registre 55 est inversée par l'inverseur 56. Une porte ET 57 a une entrée connectée à la bascule 54, et une autre entrée recevant de l'horloge 58 le signal d'horloge A, utilisé pour contrôler les bascules des différentes chaînes et appliquer le signal d'horloge A à la ligne SH DL 21 en mode LSSD lorsque la phase d'adressage est terminée.

Un registre 59 est chargé avec une information qui indique suivant l'unité RU sélectionnée le nombre d'impulsions d'horloge à envoyer sur la ligne SH ML 23. Par exemple pour adresser l'unité RU-i dans l'hypothèse où chaque circuit d'adressage 22 comporte m bascules pour adresser p chaînes dans chaque unité, il faut envoyer i × m impulsions d'horloge.

Un registre 60 est chargé avec les bits d'adresse indiquant la chaîne particulière à adresser dans l'unité sélectionnée. Le contenu de ce registre est envoyé en série sur la boucle de contrôle ML 24 sous contrôle des impulsions d'horloge SH ML 23.

Des zéros sont introduits dans le registre après chaque décalage par l'entrée FORCER 0 de façon qu'après m impulsions d'horloge (avec m = 3 dans l'exemple choisi), le contenu du registre 60 soit à 0 et que des 0 soient envoyés en ligne.

Les impulsions d'horloge sur la ligne SH ML 23 sont générées à partir du contenu du registre 59 par un circuit de contrôle 61 qui comprend une horloge 62, un circuit de comparaison 63 et une porte ET 64 ouverte en mode LSSD et ADRESSAGE. A chaque impulsion d'horloge appliquée à une entrée DECRE du registre 59, le contenu du registre est décrémenté de 1.

Au départ, le contenu du registre est égal à 0 partout, et le circuit de comparaison 63 qui compare le contenu du registre avec une configuration 0 partout fournit un signal qui ferme la porte ET 64 de telle façon qu'aucune impulsion n'apparaît sur la sortie SH ML 23.

Lorsque le registre est chargé à la valeur désirée pour adresser une unité, par exemple à 9 (0/0/1/0/0/1) pour adresser la troisième unité dans le cas où chaque unité comporte trois bascules d'adressage comme représenté sur la figure 4, le circuit 63 ouvre la porte ET 64 qui laisse passer les impulsions d'horloge sur la ligne SH ML 23. A chaque impulsion le contenu du registre 59 est décrémenté d'une unité et au bout de neuf impulsions le contenu du registre sera égal à zéro partout et les impulsions d'horloge ne seront plus envoyées sur la ligne SH ML 23.

Ces impulsions transfèrent le contenu du registre 60 sur la ligne ML 24, et la configuration de bits d'adresse de la chaîne sélectionnée dans l'unité est décalée bit après bit sur la ligne ML 24. Les trois dernières impulsions d'horloge sur la ligne SH ML 23 provoquent l'introduction de la configuration de bits dans les trois bascules d'adressage (42 à 44) de l'unité sélectionnée.

La phase d'adressage est alors terminée et la bascule 55 est remise à zéro, ce qui provoque l'envoi des impulsions d'horloge A sur la ligne SH DL 21.

Les données à envoyer à la chaîne ainsi sélectionnée sont placées dans le registre 65 pour être envoyée en série sur la boucle DL 20 par la borne DEPART. Les données extraites de la chaîne sélectée après décalage et recueillies à la borne SDO au point 33 sont réappliquées au registre 65. Lorsque toutes les données de test ont été envoyées, le registre 65 est lu, sous contrôle du programme pour que son contenu soit transféré au microprocesseur afin d'être analysé.

La chaîne des bascules d'adressage de toutes les unités est restaurée en envoyant sur la ligne SH ML 23 un nombre d'impulsions d'horloge n × m ce qui correspond à l'adressage de la dernière unité et en envoyant une configuration de bits d'adresse 0 0 0 ... dans le registre 60.

Lorsque l'on fait une opération de chargement et de lecture d'une chaîne isolée, cette chaîne est adressée et l'opération est réalisée comme précédemment décrit, ensuite les bascules d'adressage peuvent être restaurées en envoyant le nombre de zéro nécessaire sur la boucle de contrôle.

Lorsque l'on fait une opération de chargement et de lecture de l'ensemble des chaînes, on peut adresser par exemple les chaînes de même rang de toutes les unités en chargeant le numéro de chaîne désiré, par exemple 100 (chaîne 2), à chaque opération d'adressage sans forcer de zéro dans le registre 60 et en envoyant sur la ligne SH ML 23 pour chaque opération de charge-ment/lecture trois impulsions d'horloge ; de cette façon, l'information d'adresse sera propagée dans la boucle de commande. On peut ainsi réaliser l'accès séquentiel à toutes les chaînes sans effectuer de restauration.

Bien entendu, le circuit d'adressage pourrait être constitué par autant de bascules qu'il y a de chaînes dans chaque unité, une bascule permettant la sélection d'une chaîne. A ce moment la configuration de bits d'adresse n'est pas codée. Bien entendu dans cette hypothèse, le registre 60 doit avoir p positions afin d'envoyer une configuration d'adresse à p bits pour déterminer l'état des p bascules d'adressage et le nombre des impulsions d'horloge nécessaires pour propager la configuration de bits désitée sera plus grand, si bien que l'opération d'adressage prendra plus de temps.

La procédure d'adressage des différentes unités présente en outre l'avantage que l'on peut supprimer ou ajouter des unités sans avoir à apporter des modifications dans les circuits. Il suffit simplement de changer le nombre des impulsions d'horloge sur la ligne SH ML 23.

## Revendications

1. Dispositif de chargement et de lecture de chaînes de bascules à décalage utilisable pour le test, le dépannage et l'initialisation d'un système de traitement de données dont les composants sont disposés sur n unités remplaçables (RU) qui comportent chacune p chaînes de bascules, ledit dispositif comportant un circuit de commande (10) générant une configuration de bits d'adresse et traitant les données à envoyer dans la chaîne sélectionnée (41-j) et les données reçues de la chaîne sélectionnée (41-j), et étant caractérisé en ce que :

une boucle de contrôle (ML 24) est connectée au circuit de commande et reçoit de ce dispositif de commande la configuration de bits d'adresse qui sont envoyés en série sur la boucle,

un circuit d'adressage (Mi 22) est placé dans chaque unité remplaçable, sensible à la configuration des bits d'adresse sur la boucle de contrôle, ledit circuit comporte p sorties et fournit sur une des p sorties qui est déterminée par la configuration des bits d'adresse un signal de sélection de chaîne, ledit circuit d'adressage comprenant au moins une bascule d'adressage (42, 43, 44), lesdites bascules d'adressage dans les différentes unités remplaçables étant connectées de façon à constituer un registre à décalage,

le circuit de commande comprend des premiers moyens de génération d'impulsions d'horloge (59. 61) qui envoient sur une première ligne de sortie (SH ML 23) dudit circuit de commande des premières impulsions d'horloge dont le nombre est fonction de l'unité dans laquelle se trouve la chaîne à sélectionner, ces impulsions étant appliquées en parallèle aux bascules d'adressage pour provoquer le décalage de la configuration des bits d'adresse dans le registre formé par les bascules d'adressage,

toutes les unités remplaçables sont connectées à une boucle de données (DL 20) sur laquelle le circuit de commande envoie les données à charger dans la chaîne sélectionnée et de laquelle il reçoit les données lues de ladite chaîne,

une première série de p portes d'entrée (38) placée dans chaque unité remplaçable, chacune desdites portes étant connectée à une des p sorties du circuit d'adressage pour être ouverte par le signal de sélection de chaîne afin d'autoriser le chargement des données provenant de la boucle de données dans la chaîne sélectionnée.

2. Dispositif selon la revendication 1 caractérise en ce que les circuits d'adressage comportent chacun m bascules (42, 43, 44) avec $p = 2^m$, les m bascules de tous les circuits étant connectées pour former un registre à décalage, et un sélecteur de chaîne (48) ayant p sorties sensible à l'état des bascules d'adressage pour fournir sur une des p sorties le signal de sélection d'adresse.

3. Dispositif selon la revendication 1 ou 2 caractérisé en ce que le nombre des impulsions d'horloge est égal à $m \times i$ avec i compris entre 1 et n, lorsque la chaîne à sélectionner se trouve dans le $i^{ième}$ unité remplaçable (RU-i).

4. Dispositif selon la revendication 1, 2 ou 3 caractérisé en ce que le circuit de commande comprend des seconds moyens de génération d'impulsions d'horloge (54 à 58) pour générer sur une seconde ligne de sortie du circuit de commande (SH DL 21) des secondes impulsions d'horloge lorsque la chaîne à sélectionner a été adressée, ces secondes impulsions étant appliquées à chacune des p portes d'entrée (38) de toutes les unités remplaçables, afin que la porte ouverte par le circuit d'adressage provoque l'application desdites secondes impulsions à la chaîne sélectionnée pour y charger les données qui circulent sur la boucle de données.

5. Dispositif selon l'une quelconque des revendications précédentes caractérisé en ce que chaque unité remplaçable (RU) comporte une seconde série de p portes de sortie (40) chacune desdites portes étant ouverte par une des sorties du circuit d'adressage afin de faire passer le contenu de la chaîne sélectionnée sur la boucle de données.

6. Dispositif selon l'une quelconque des revendications 3 à 5, caractérisé en ce que le circuit de commande (10) comprend des moyens (60) pour générer la configuration des bits d'adresse qui sont envoyés en série sur la boucle de contrôle et introduits sous contrôle des premières impulsions d'horloge dans le registre à décalage formé par les bascules d'adressage, cette configuration de bits d'adresse comportant m bits représentant le numéro de la chaîne à adresser codés en binaire précédés de $(i-1) \times m$ zéros.

## Claims

1. A device for loading data in and reading data out of strings of shift register latches operable for testing, troubleshooting and initializing a data processing system the circuitry of which is provided on n field replaceable units (RU's) including each p strings of latches, said device comprising a control circuit (10) that generates a configuration of address bits and processes the data to be sent over a selected string (41-j) and the data received from said selected string (41-j), and being characterized in that :

a monitoring loop (ML 24) is connected to the control circuit and receives therefrom the configuration of address bits serially transmitted over the loop,

an addressing circuit (Mi 22) is located in each field replaceable unit and responsive to the configuration of address bits present in the monitoring loop, said circuit having p outputs and providing a string selection signal at one of the p outputs which is determined by the configuration of address bits, said adressing circuit comprising at least one addressing latch (42, 43, 44), said addressing latches in the various field replaceable units being connected to form a shift register,

the control circuit includes first clock pulses generating means (59, 61) that send over a first output line (SH ML 23) of said control circuit, first clock pulses the number of which depends upon the unit in which the string to be selected is located, said pulses being applied in parallel to the addressing latches to cause the configuration of address bits to be shifted in the register formed by the addressing latches,

all the field replaceable units are connected to a data loop (DL 20) over which the control circuit sends the data to be loaded into the selected string and from which it receives the data read out of said string,

a first group of p input gates (38) located in each field replaceable unit, each of said gates being connected to one of the p outputs of the addressing circuit to be enabled by the string selection signal so as to allow the data from the data loop to be loaded into the selected string.

2. A device according to claim 1 characterized in that the addressing circuits comprise each m latches (42, 43, 44), with $p = 2^m$, the m latches of all circuits being interconnected to form a shift register, and a p-output string selector (48) responsive to the state of the addressing latches to provide the string selection signal at one of the p outputs.

3. A device according to claim 1 or 2 characterized in that the number of clock pulses is equal to $m \times i$, with i being in the range of 1 to n, when the string to be selected is located in the $i^{th}$ field replaceable unit (RU-i).

4. A device according to claim 1, 2 or 3, characterized in that the control circuit includes second clock pulse generating means (54 to 58) for generating second clock pulses on a second output line (SH DL 21) of the control circuit when the string to be selected has been addressed, said second clock pulses being applied to each of the p input gates (38) of all field replaceable units in order that the gate activated by the addressing circuit may cause said second pulses to be applied to the selected string to charge therein the data propagating in the data loop.

5. A device according to any one of the previous claims, characterized in that each field replaceable unit (RU) includes a second group of p output gates (40) each of which is activated by one of the outputs of the addressing circuit to transfer the contents of the selected string to the data loop.

6. A device according to any one of claims 3 to 5, characterized in that control circuit (10) includes means (60) for generating the configuration of address bits serially transmitted over the monitoring loop and loaded under control of the first clock pulses in the shift register formed by the addressing latches, said configuration of address bits comprising m bits representing the binary coded number of the string to be addressed preceded by (i-1) × m zeroes.

**Patentansprüche**

1. Lade- und Lesevorrichtung von Kippgliedketten mit Verschiebung, die für Test, Entstörung und Initialisierung eines Datenverarbeitungssystems verwendbar ist, dessen Komponenten auf n austauschbaren Einheiten (RU) angeordnet sind, die jeweils p Kippgliedketten aufweisen, wobei die genannte Vorrichtung einen Steuerkreis (10) umfasst, der eine Konfiguration von Adressenbits erzeugt und die Daten verarbeitet, die der angewählten Kette (41-j) zu übermitteln sind, sowie auch die, die von der angewählten Kette (41-j) empfangen werden, und die dadurch gekennzeichnet ist, dass :

eine Kontrollschleife (ML 24) mit dem Steuerkreis verbunden ist und von dieser Steuervorrichtung die Konfiguration der Adressenbits erhält, die in Reihe der Schleife übertragen werden,

ein Adressier-Schaltkreis (Mi 22) in jeder austauschbaren Einheit vorgesehen ist, der auf die Konfiguration der Adressenbits in der Kontrollschleife anspricht, wobei der genannte Schaltkreis p Ausgänge beinhaltet und über einen der p Ausgänge, der durch die Konfiguration der Adressenbits bestimmt wird, einen Kettenwahlsignal ausgibt, wobei der genannte Adressier-Schaltkreis mindestens ein Adressier-Kippglied (42, 43, 44) aufweist und die genannten Adressier-Kippglieder der verschiedenen austauschbaren Einheiten so verbunden sind, dass sie ein Schiftregister darstellen,

der Steuerkreis erste Taktimpulserzeugungsmittel (59, 61) umfasst, die über eine erste Ausgangsleitung (SH ML 23) des genannten Steuerkreises erste Taktimpulse ausgeben, deren Anzahl von der Einheit abhängt, in der sich die zu wählende Kette befindet, wobei diese Impulse parallel an die Adressier-Kippglieder gelegt werden, um eine Verschiebung der Adressenbits in den von den Adressier-Kippgliedern geformten Registern hervorzurufen,

alle austauschbaren Einheiten mit einer Datenschleife (DL 20) verbunden sind, welche vom Steuerkreis in der gewählten Kette einzulagernde Daten erhält und die diesem Steuerkreis ebenfalls in der genannten Kette gelesene Daten überträgt,

eine erste Reihe von p Eingangstoren (38) in jeder austauschbaren Einheit vorgesehen ist, wobei jedes der genannten Tore mit einem der p Ausgänge des Adressierkreises verbunden ist, um vom Wahlsignal der Kette geöffnet zu werden mit dem Ziel, das Einlagern der von der Datenschleife kommenden Daten in der gewählten Kette freizugeben.

2. Vorrichtung nach Anspruch 1, dadurch gekennzeichnet, dass die Adressierkreise jeweils m Kippglieder (42, 43, 44) mit $p = 2^m$ aufweisen, wobei die m Kippglieder aller Kreise verbunden sind, um ein Shiftregister zu bilden, sowie auch einen Kettenwahlschalter (48) mit p Ausgängen, die auf den Zustand der Adressier-Kippglieder ansprechen, um auf einem der p Ausgänge das Signal zur Adressenwahl zu erstellen.

3. Vorrichtung nach Anspruch 1 oder 2, dadurch gekennzeichnet, dass die Anzahl der Taktimpulse m × i gleich ist, wobei i zwischen 1 und n liegt, wenn die zu wählende Kette sich in der i. austauschbaren Einheit (RU-i) befindet.

4. Vorrichtung nach Anspruch 1, 2 oder 3, dadurch gekennzeichnet, dass der Steuerkreis zweite Mittel zur Erzeugung von Taktimpulsen (54 bis 58) aufweist, um auf einer zweiten Ausgangsleitung des Steuerkreises (SH DL 21) zweite Taktimpulse zu erzeugen, wenn die zu wählende Kette adressiert worden, wobei diese zweiten Impulsionen an jedes der p Eingangstore (38) aller austauschbaren Einheiten übertragen werden, damit das vom Adressier-Schaltkreis geöffnete Tor das Übersenden der genannten zweiten Impulsionen an die gewählte Kette bewirkt, um dort die in der Datenschlaufe laufenden Daten einzulagern.

5. Vorrichtung nach allen der vorstehend angeführten Ansprüche, dadurch gekennzeichnet, dass jede der austauschbaren Einheiten (RU) eine zweite Serie von p Ausgangstoren (40) aufweist, die jeweils von einem der zu den Adressier-Schaltkreisen gehörenden Ausgänge geöffnet werden, um den Inhalt der gewählten Kette auf die Datenschleife zu übertragen.

6. Vorrichtung nach einem der Ansprüche 3 bis 5, dadurch gekennzeichnet, dass der Steuerkreis (10) Mittel (60) aufweist, mit deren Hilfe eine Konfiguration von Adressenbits erzeugt wird, die in Reihe der Kontrollschleife übertragen werden und dann unter Kontrolle der ersten Taktimpulse in das Schiftregister eingelesen werden, das von den Adressier-Kippgliedern gebildet wird, wobei diese Konfiguration von Bitadressen m Bits aufweist, die die zu adressierende Kettennummer darstellen und die binär codiert sind, während ihnen (i-1) × m Nullen vorangehen.

# FIG. 1

# FIG. 2

0 104 293

# FIG.3

**RU-i**

35 SDI Mi 22

DE ML24 → | L1 | | L2 | SDO 37

ENTREE → A

36 A ML 24 SORTIE

DE SH ML 23

SRL-i 34 38

39 32

DE 8 CHAINES RU-i 30

SH DL SDI-i L1/L2 ... L1/L2 40

21 8

SDO-i

31 33

2

FIG. 4

FIG. 5

0 104 293